# EUROPÄISCHE PATENTSCHRIFT

(11) **EP 2 368 269 B1**
(45) Veröffentlichungstag und Bekanntmachung des Hinweises auf die Patenterteilung: **16.03.2016**
(21) Anmeldenummer: 09801388.1
(22) Anmeldetag: 27.11.2009
(51) Int. Cl.: H01L 27/15, H01L 33/38, H01L 33/62

(54) **OPTOELEKTRONISCHE PROJEKTIONSVORRICHTUNG**
OPTOELECTRONIC PROJECTION APPARATUS
DISPOSITIF DE PROJECTION OPTOÉLECTRONIQUE

(30) Priorität: 23.12.2008 DE 102008062933
(43) Veröffentlichungstag der Anmeldung: 28.09.2011
(73) Patentinhaber: OSRAM Opto Semiconductors GmbH, 93055 Regensburg (DE)
(72) Erfinder: VON MALM, Norwin, 93152 Nittendorf - Thumhausen (DE); STREUBEL, Klaus, 93164 Laaber (DE); RODE, Patrick, 93051 Regensburg (DE); ENGL, Karl, 93080 Niedergebraching (DE); HÖPPEL, Lutz, 93087 Alteglofsheim (DE); MOOSBURGER, Jürgen, 93055 Regensburg (DE)
(74) Vertreter: Epping - Hermann - Fischer
(86) Internationale Anmeldenummer: PCT/DE2009/001694
(87) Internationale Veröffentlichungsnummer: WO 2010/072191

(56) Entgegenhaltungen:
- WO-A2-2006/061728
- DE-A1-102007 022 947
- JP-A- 2004 311 677
- US-A1- 2002 113 246
- US-A1- 2008 185 972
- US-B1- 6 633 134

## Beschreibung

Die vorliegende Erfindung betrifft eine optoelektronische Projektionsvorrichtung mit einem Halbleiterkörper, der ein Bild gebendes Element der Projektionsvorrichtung ist.

Aus der Patentschrift WO 2008/060053 A1 ist beispielsweise eine Vorrichtung bekannt, die ein auf einem Siliziumsubstrat angeordnetes Array aus SiN basierten LEDs umfasst, wobei die LEDs in einer zweidimensionalen regelmäßigen Matrix aus n Zeilen und m Spalten angeordnet und miteinander verschaltet sind. Die LEDs weisen jeweils auf einer Vorderseite und auf einer Rückseite eine Kontaktierung auf, wobei jeweils die Vorderseite der LEDs als Strahlungsaustrittsseite ausgebildet ist. Dadurch ergeben sich nachteilig Abschattungseffekte an der Strahlungsaustrittsseite der LEDs, die zu einer inhomogenen Abstrahlcharakteristik der LEDs führen.

Ein Array aus LEDs ist ferner in der Patentschrift WO 2001/097295 A2 beschrieben. Aus einem InGaN-Wafer sind regelmäßig angeordnete zylinderförmige LEDs herausgelöst. Auch diese LEDs sind von einer Vorderseite und einer Rückseite elektrisch kontaktiert, wodurch sich nachteilig Abschattungseffekte und eine damit verbundene inhomogene Abstrahlcharakteristik ergeben.

In der Druckschrift US 2002/01133246 A1 ist eine Licht emittierende Vorrichtung mit einer Vielzahl von Licht emittierenden Bauteilen angegeben.

Die Druckschrift DE 10 2007 022 947 A1 betrifft einen optoelektronischen Halbleiterkörper.

Die Druckschrift US 2008/0185972 A1 betrifft eine ein Bild erzeugende optoelektronische Projectionsvorrichtung, die eine Leuchtdioden-Array umfasst.

Ein Licht emittierendes Halbleiterbauteil ist in der Druckschrift JP 2004-311677 A angegeben.

Aus der Druckschrift US 6,633,134 B1 ist ein Display mit organischen, elektrolumineszenten Materialien bekannt.

Der Erfindung liegt die Aufgabe zugrunde, eine optische Projektionsvorrichtung anzugeben, die besonders Platz sparend und gleichzeitig flexibel einsetzbar ist.

Diese Aufgabe wird unter anderem durch eine optoelektronische Projektionsvorrichtung mit den Merkmalen des Patentanspruchs 1 gelöst. Vorteilhafte Ausführungsformen und bevorzugte Weiterbildungen der Projektionsvorrichtung sind Gegenstand der abhängigen Ansprüche.

Erfindungsgemäß ist eine optoelektronische Projektionsvorrichtung vorgesehen, die im Betrieb ein vorgegebenes Bild erzeugt. Die Projektionsvorrichtung umfasst einen Halbleiterkörper, der eine zur Erzeugung von elektromagnetischer Strahlung geeignete aktive Schicht und eine Strahlungsaustrittsseite aufweist. Der Halbleiterkörper ist ein Bild gebendes Element der Projektionsvorrichtung. Zur elektrischen Kontaktierung des Halbleiterkörpers sind eine erste Kontaktschicht und eine zweite Kontaktschicht an einer der Strahlungsaustrittsseite gegenüberliegenden Rückseite des Halbleiterkörpers angeordnet und mittels einer Trennschicht elektrisch voneinander isoliert.

Durch die an der Rückseite des Hableiterkörpers angeordnete erste und zweite Kontaktschicht werden mit Vorteil Abschattungseffekte vermieden, die durch eine auf der Strahlungsaustrittsseite des Halbleiterkörpers angeordnete Kontaktschicht entstehen können. Insgesamt verbessern sich dadurch die Strahlungseffizienz des Halbleiterkörpers sowie die Strahlungshomogenität.

Der Halbleiterkörper ist ein Bild gebendes Element der Projektionsvorrichtung. Insbesondere wird das von der Projektionsvorrichtung im Betrieb erzeugte Bild nicht von einem weiteren Element, wie beispielsweise einer Schablone, einem Dia oder einem Lichtmodulator, wie beispielsweise einem LCD-Panel oder einem Mikrospiegel-Array, erzeugt, sondern der Halbleiterkörper selbst ist das Bild gebende Element. Eine optoelektronische Projektionsvorrichtung, die sich insbesondere durch Platz sparende Eigenschaften auszeichnet und gleichzeitig flexibel einsetzbar ist, ermöglicht sich mit Vorteil. Insbesondere ergibt sich so eine miniaturisierte Projektionsvorrichtung.

Bei dem Halbleiterkörper handelt es sich beispielsweise um einen Leuchtdiodenchip oder einen Laserdiodenchip. Der Halbleiterkörper ist vorzugsweise ein Dünnfilm-Halbleiterkörper. Als Dünnfilm-Halbleiterkörper wird im Rahmen der Anmeldung ein Halbleiterkörper angesehen, während dessen Herstellung das Aufwachssubstrat, auf den eine Halbleiterschichtenfolge, die den Halbleiterkörper umfasst, beispielsweise epitaktisch, aufgewachsen wurde, abgelöst worden ist.

Die aktive Schicht des Halbleiterkörpers weist bevorzugt einen pn-Übergang, eine Doppelheterostruktur, einen EinfachQuantentopf (SQW, Single Quantum Well) oder eine Mehrfach-Quantentropfstruktur (MQW, Multi-Quantum Well) zur Strahlungserzeugung auf. Die Bezeichnung Quantentopfstruktur entfaltet hierbei keine Bedeutung hinsichtlich der Dimensionalität der Quantisierung. Sie umfasst somit unter anderem Quantentröge, Quantendrähte und Quantenpunkte und jede Kombination dieser Strukturen.

Der Halbleiterkörper weist eine Strahlungsaustrittsseite auf, durch die im Halbleiterkörper erzeugte Strahlung den Halbleiterkörper verlassen kann. Die Strahlungsaustrittsseite ist dabei vorzugsweise durch eine Hauptseite des Halbleiterkörpers gebildet. Insbesondere ist die Strahlungsaustrittsseite durch diejenige Hauptseite des Halbleiterkörpers gebildet, welche einer Montageseite des Halbleiterkörpers gegenüber liegt. Vorzugsweise tritt kein oder kaum Licht durch Seitenflächen des Halbleiterkörpers aus.

Bevorzugt erzeugt die optoelektronische Projektionsvorrichtung im Betrieb ein vorgegebenes Bild. Insbesondere wird im Betrieb der Projektionsvorrichtung von dieser ein Bild, welches vorgegeben und damit vorbestimmt ist, erzeugt. Dieses Bild kann beispielsweise auf eine Projektionsfläche abgebildet werden.

Der Halbleiterkörper ist zur Emission elektromagnetischer Strahlung von der Strahlungsaustrittsseite vorgesehen. An der der Strahlungsaustrittsseite gegenüberliegenden Rückseite sind eine erste und eine zweite elektrische Kontaktschicht angeordnet. Die erste und die zweite elektrische Kontaktschicht sind mittels einer Trennschicht elektrisch voneinander isoliert.

Es ist nicht zwingend notwendig, dass die gesamte erste bzw. zweite elektrische Kontaktschicht an der Rückseite angeordnet ist. Vielmehr erstreckt sich ein Teilbereich der ersten Kontaktschicht von der Rückseite durch einen Durchbruch der aktiven Schicht hindurch in Richtung zu der Strahlungsaustrittsseite hin. Zwischen der ersten Kontaktschicht und der zweiten Kontaktschicht ist die Trennschicht angeordnet, wobei sich in Draufsicht auf den Halbleiterkörper bevorzugt die erste Kontaktschicht und die zweite Kontaktschicht lateral überlappen.

Vorteilhafterweise ist die Strahlungsaustrittsseite des Halbleiterkörpers frei von elektrischen Anschlussstellen, wie beispielsweise Bondpads. Die Gefahr einer Abschattung und/oder Absorption eines Teils der von der aktiven Schicht im Betrieb emittierten Strahlung durch die elektrischen Anschlussstellen wird auf diese Weise minimiert.

Ferner kann mit Vorteil auf aufwändige Verfahrensschritte in Verbindung mit der Herstellung solcher auf der Strahlungsaustrittsseite angeordneter Anschlussstellen und/oder auf Maßnahmen, die die Strominjektion in Bereiche des Halbleiterkörpers unterhalb der elektrischen Anschlussstelle einschränken oder verhindern, verzichtet werden. Beispielsweise ist vorzugsweise ein Polieren der vorderseitigen Oberfläche des Halbleiterkörpers und/oder eine Herstellung von Metallstegen zur Stromaufweitung, die eine große Dicke, aber geringe laterale Ausdehnung aufweisen, nicht zwingend notwenig. Ferner kann mit Vorteil zum Beispiel auf das Ausbilden einer elektrisch isolierenden Schicht, einer Schottky-Barriere und/oder eines Ionen implantierten Bereichs unterhalb der Anschlussstelle verzichtet werden.

Bei einer bevorzugten Ausgestaltung der optoelektronischen Projektionsvorrichtung ist die zweite Kontaktschicht in Form von Pixeln strukturiert, wobei sich im Betrieb der Projektionsvorrichtung durch die Projektion der Pixel zumindest ein Teil des vorgegebenen Bildes ergibt.

Bevorzugt ergibt sich durch die Projektion der Pixel das vollständig vorgegebene Bild. Die zweite Kontaktschicht kann stellenweise, entsprechend der Pixel, geschädigt werden, sodass geschädigte Bereiche keinen oder kaum mehr Strom leiten. Bereiche der zweiten Kontaktschicht, welche geschädigt sind, bestromen die aktive Schicht nicht oder kaum. Auf diese Weise leuchten nur ausgewählte Bereiche der aktiven Schicht. Diese ausgewählten Bereiche der aktiven Schicht, welche Licht erzeugen, sind für die Bildung des vorgegebenen Bildes verantwortlich. Die Strukturierung der zweiten Kontaktschicht kann dabei durch stellenweises Entfernen, stellenweise Ionenimplantation oder Diffusion von Dotierstoffen in die zweite Kontaktschicht erfolgen.

Bei einer bevorzugten Ausgestaltung der Projektionsvorrichtung sind die Pixel in einer zweidimensionalen Segment-Anzeige angeordnet. Bevorzugt sind die Pixel in einer zweidimensionalen Sieben-Segment-Anzeige angeordnet.

Insbesondere tragen so nur Bereiche der Strahlungsaustrittsseite des Halbleiterkörpers, unterhalb derer in vertikaler Richtung ein Pixel der zweiten Kontaktschicht angeordnet ist, zur Emission von Strahlung bei. In diesem Fall leuchten nur ausgewählte Bereiche der aktiven Schicht, welche vertikal über der zweiten Kontaktschicht, insbesondere der Pixel der zweiten Kontaktschicht, angeordnet sind.

Bei einer weiteren bevorzugten Ausgestaltung sind die Pixel in einer zweidimensionalen regelmäßigen Matrix aus n Zeilen und m Spalten angeordnet.

Bei einer weiteren bevorzugten Ausgestaltung der Projektionsvorrichtung weist die zweite Kontaktschicht zumindest eine Struktur in Form eines Piktogramms, Zeichens, Buchstabens oder Schriftzuges auf. Vorzugsweise weist die zweite Kontaktschicht eine Mehrzahl von Strukturen jeweils in Form eines Piktogramms, Zeichens, Buchstabens oder Schriftzuges auf.

Insbesondere ist in diesem Fall jede Struktur der zweiten Kontaktschicht ein bereits vollständiges Piktogramm oder Zeichen. Mit Vorteil ermöglicht sich so die Projektion von mehreren Zeichen, Zeichenketten und/oder Schriftzügen.

Bei einer bevorzugten Ausgestaltung ist der Halbleiterkörper zu einem Muster strukturiert, wobei sich im Betrieb der Projektionsvorrichtung durch Projektion des Musters zumindest ein Teil des vorgegebenen Bildes ergibt.

Besonders bevorzugt ergibt sich durch die Projektion des Musters das vollständige vorgegebene Bild.

Die Strukturierung des Halbleiterkörpers zu einem Muster kann dabei beispielsweise durch ein Ätzverfahren erfolgen, wobei das zu erzeugende Muster durch ein lithografisches Verfahren definiert wird. Beispielsweise kann der Halbleiterkörper dazu stellenweise vollständig entfernt sein. Es ist aber auch möglich, dass nur Teile des Halbleiterkörpers, wie beispielsweise Strom leitende Schichten, entfernt sind. Insgesamt entsteht das als Bild darzustellende Muster durch die Bereiche der Strahlungsaustrittsseite des Halbleiterkörpers, welche nach Fertigstellung des Halbleiterkörpers, insbesondere nach erfolgter Strukturierung des Halbleiterkörpers, im Betrieb Licht emittieren.

Soll beispielsweise von der optoelektronischen Projektionsvorrichtung ein leuchtender Stern als Bild dargestellt werden, so kann der Halbleiterkörper bis auf einen sternförmigen Bereich vollständig entfernt werden. Im Betrieb des Halbleiterkörpers leuchtet dann nunmehr der sternförmige Bereich. Der Halbleiterkörper ist dabei das Bild gebende Element, wobei das Muster durch den Stern gebildet ist. Insbesondere kann in diesem Fall eine zu einem Muster strukturierte organische Leuchtdiode (OLED) zur Anwendung kommen.

Bei dieser Ausgestaltung ist mit Vorteil die Lichterzeugung auf die selektiv leuchtenden Bereiche des Halbleiterkörpers konzentriert.

In den entfernten Bereichen des Halbleiterkörpers ist bei einer bevorzugten Ausgestaltung ein reflektierendes Material angeordnet. Als reflektierende Materialien kommen beispielsweise Metalle, zum Beispiel Ag, oder Materialien mit einem niedrigen Brechungsindex, zum Beispiel SiO₂, in Betracht. Dadurch kann Strahlung, die von den selektiv leuchtenden Bereichen des Halbleiterkörpers in Richtung der jeweiligen benachbarten selektiv leuchtenden Bereiche des Halbleiterkörpers emittiert wird, an dem reflektierenden Materialien in Richtung Strahlungsaustrittsseite reflektiert und dort ausgekoppelt werden. Insbesondere verbessert sich so die Effizienz der Projektionsvorrichtung mit Vorteil.

Zusätzlich kann ein optisches Übersprechen zwischen den einzelnen selektiv leuchtenden Bereichen des Halbleiterkörpers mit Vorteil verhindert werden. Unter einem optischen Übersprechen ist insbesondere die Emission von Strahlung aus einem selektiv leuchtenden Bereich des Halbleiterkörpers in einen benachbarten ausgeschalteten selektiv leuchtenden Bereich zu verstehen. Die Folge des optischen Übersprechens ist ein reduzierter Kontrast der Projektionsvorrichtung. Das reflektierende Material verbessert so mit Vorteil den Kontrast der Projektionsvorrichtung sowie die Effizienz der Projektionsvorrichtung.

Bei einer bevorzugten Ausgestaltung ist die erste Kontaktschicht an der von dem Halbleiterkörper abgewandten Seite der zweiten Kontaktschicht angeordnet. Besonders bevorzugt weist die zweite Kontaktschicht eine Mehrzahl von Öffnungen auf, durch die die erste Kontaktschicht zu dem Halbleiterkörper verläuft.

Insbesondere ist in diesem Fall zwischen der ersten Kontaktschicht und der zweiten Kontaktschicht eine elektrisch isolierende Trennschicht angeordnet. Die elektrisch isolierende Trennschicht weist bevorzugt in den Bereichen der Öffnungen der zweiten Kontaktschicht Öffnungen auf, durch die die erste Kontaktschicht verläuft. Insbesondere ist die erste Kontaktschicht elektrisch isoliert von der zweiten Kontaktschicht angeordnet. Die erste Kontaktschicht verläuft demnach von der zweiten Kontaktschicht elektrisch isoliert durch die Öffnungen der zweiten Kontaktschicht zu dem Halbleiterkörper. Dies kann vorzugsweise durch die elektrisch isolierende Trennschicht realisiert werden.

Bei einer bevorzugten Ausgestaltung erstreckt sich ein Teilbereich der ersten Kontaktschicht von der Rückseite durch einen Durchbruch der aktiven Schicht hindurch in Richtung zu der Strahlungsaustrittsseite hin.

Besonders bevorzugt verläuft der Teilbereich der ersten Kontaktschicht, der durch die Öffnungen der Trennschicht und der zweiten Kontaktschicht verläuft, von der Rückseite durch den Durchbruch der aktiven Schicht hindurch in Richtung zu der Strahlungsaustrittsseite hin. Vorzugsweise verläuft die erste Kontaktschicht dabei elektrisch isoliert von dem Halbleiterkörper in dem Halbleiterkörper zu dem Durchbruch der aktiven Schicht.

Bei einer weiteren Ausgestaltung weist die erste Kontaktschicht mindestens einen elektrischen Anschlussbereich auf, der zur elektrischen Kontaktierung des Halbleiterkörpers an einer der Strahlungsaustrittsseite zugewandten Seite der aktiven Schicht geeignet ist. Insbesondere ist die erste Kontaktschicht mittels der Teilbereiche, die von der Rückseite durch den Durchbruch der aktiven Schicht hindurch in Richtung zu der Strahlungsaustrittsseite hin führen, zur elektrischen Kontaktierung des Halbleiterkörpers an der der Strahlungsaustrittsseite zugewandten Seite der aktiven Schicht geeignet.

Insbesondere ist der Anschlussbereich an der Rückseite des Halbleiterkörpers angeordnet. Dadurch können mit Vorteil eine Abschattung und/oder Absorption der von der aktiven Schicht emittierten Strahlung in dem Anschlussbereich vermieden werden.

Bei einer bevorzugten Ausgestaltung der Projektionsvorrichtung ist die erste Kontaktschicht in Form von Strukturen strukturiert und weist eine Mehrzahl von elektrischen Anschlussbereichen auf, wobei jeweils eine Struktur mit einem Anschlussbereich elektrisch leitend verbunden ist.

Insbesondere ist so eine getrennte elektrische Ansteuerung der Strukturen der ersten Kontaktschicht möglich. Durch eine geeignete elektrische Ansteuerung der einzelnen Strukturen der ersten Kontaktschicht können so mit Vorteil, insbesondere mit ein und demselben Halbleiterkörper, verschiedene Bilder erzeugt werden. Durch entsprechendes Bestromen des Halbleiterkörpers können die Strukturen der ersten Kontaktschicht unabhängig voneinander bestromt werden. Auf diese Weise können mit einem einzigen Halbleiterkörper verschiedene vorgebbare Bilder unabhängig voneinander erzeugt werden.

Bei einer weiteren bevorzugten Ausgestaltung der Projektionsvorrichtung ist die zweite Kontaktschicht in Form von Pixeln strukturiert und weist eine Mehrzahl von elektrischen Anschlussflächen auf, wobei jeweils ein Pixel mit einer Anschlussfläche elektrisch leitend verbunden ist.

Die einzelnen Pixel können so getrennt voneinander elektrisch angesteuert werden. Eine unabhängige Bestromung der Pixel der zweiten Kontaktschicht ermöglicht sich so, wodurch verschiedene vorgebbare Bilder unabhängig voneinander erzeugt werden können.

Besonders bevorzugt sind die erste Kontaktschicht in Form von Strukturen strukturiert und die zweite Kontaktschicht in Form von Pixeln strukturiert, wobei vorzugsweise die Strukturen der ersten Kontaktschicht und die Pixel der zweiten Kontaktschicht getrennt voneinander elektrisch ansteuerbar sind. Eine unabhängige Bestromung der Bereiche der ersten und zweiten Kontaktschicht ist somit möglich, wodurch mit einem einzigen Halbleiterkörper verschiedene vorgebbare Bilder unabhängig voneinander erzeugt werden können. Eine flexible optoelektronische Projektionsvorrichtung ermöglicht sich mit Vorteil.

Bei einer bevorzugten Ausgestaltung der optoelektronischen Projektionsvorrichtung sind auf der Strahlungsaustrittsseite des Halbleiterkörpers bereichsweise Strahlungsauskoppelstrukturen angeordnet.

Insbesondere sind lediglich auf den Bereichen der Strahlungsaustrittsseite des Halbleiterkörpers, unterhalb derer in vertikaler Richtung jeweils ein Pixel der zweiten Kontaktschicht angeordnet ist, Strahlungsauskoppelstrukturen angeordnet. Dadurch verbessert sich die Strahlungsauskopplung der von dem Halbleiterköper emittierten Strahlung in ausgewählten Bereichen des Halbleiterkörpers, welche vertikal über der zweiten Kontaktschicht, insbesondere über den Pixeln der zweiten Kontaktschicht, angeordnet sind. Diese ausgewählten Bereiche der Strahlungsaustrittsseite entsprechen den Bereichen des Halbleiterkörpers, die für die Bildung des vorgegebenen Bildes verantwortlich sind.

Mit Vorteil verbessert sich in Bereichen der Strahlungsaustrittsseite, die Strahlungsauskoppelstrukturen aufweisen, die Auskopplung der von dem Halbleiterkörper emittierten Strahlung, wodurch sich die Effizienz des Halbleiterkörpers mit Vorteil steigert.

An der Grenzfläche des Halbleiterkörpers erfolgt ein Sprung des Brechungsindex von dem Material des Halbleiterkörpers einerseits zu dem umgebenden Material andererseits. Dadurch kommt es zu einer Brechung des Lichts beim Übergang vom Halbleiterkörper in die Umgebung. Je nach Winkel, in dem ein Lichtstrahl auf die Grenzfläche auftrifft, kann es zur Totalreflektion kommen. Aufgrund der parallelen Oberflächen des Halbleiterkörpers trifft der reflektierte Lichtstrahl im gleichen Winkel auf der gegenüber liegenden Grenzfläche auf, so dass auch dort Totalreflektion auftritt. Die Folge ist, dass der Lichtstrahl somit nichts zur Lichtabstrahlung beitragen kann. Dadurch, dass auf der Strahlungsaustrittsseite Strahlungsauskoppelstrukturen angeordnet sind, wird der Winkel verändert, in dem ein Lichtstrahl auf die Oberfläche auftrifft.

Unter Strahlungsauskoppelstrukturen sind vor allem Oberflächenstrukturierungen zu verstehen. Insbesondere kann eine verbesserte Lichtauskopplung etwa durch ein Höhenprofil der Strahlungsaustrittsseite, beispielsweise eine Mikroprismenstrukturierung, oder eine Rauhigkeitserhöhung der Strahlungsaustrittsseite ermöglicht werden. Sind Aufrauungen der Strahlungsaustrittsseite vorgesehen, ist dadurch eine unregelmäßige Oberfläche gebildet, die die Auskopplung von Licht verbessert.

Bei einer bevorzugten Ausgestaltung der optoelektronischen Projektionsvorrichtung ist dem Halbleiterkörper auf der Strahlungsaustrittsseite ein Wellenlängen-Konversionselement nachgeordnet. Insbesondere tritt so zumindest ein Teil des durch die Strahlungsaustrittsseite des Halbleiterkörpers austretenden Lichts durch das Wellenlängen-Konversionselement, wodurch die von dem Halbleiterkörper emittierte Strahlung einer Wellenlänge zumindest teilweise in Strahlung einer anderen Wellenlänge konvertiert wird. Dadurch kann mit Vorteil eine Projektionsvorrichtung erzeugt werden, die mehrfarbiges Licht emittiert.

Besonders vorteilhaft weist ein Halbleiterkörper eine Mehrzahl von benachbarten selektiv leuchtenden Bereichen auf, wobei eine regelmäßige Anordnung von Wellenlängen-Konversionselementen auf der Strahlungsaustrittsseite angeordnet ist. Insbesondere umfasst die regelmäßige Anordnung vorzugsweise grün emittierendes Konversionselement auf jedem ersten selektiv leuchtenden Bereich, rot emittierendes Konversionselement auf jedem zweiten selektiv leuchtenden Bereich und fehlendes Konversionselement auf jedem dritten selektiv leuchtenden Bereich. Als grün beziehungsweise rot emittierendes Konversionselement ist insbesondere ein Konversionselement zu verstehen, welches vom Halbleiterkörper emittierte Strahlung in Strahlung im grünen beziehungsweise im roten Wellenlängenbereich umwandelt.

So kann mit Vorteil ein vollfarbiger Halbleiterkörper erzeugt werden, welcher in der Projektionsvorrichtung vollfarbige Bilder projizieren kann.

Die Strukturierung der verschiedenen Konversionselemente kann beispielsweise durch Ätzen von optischen Halbleitermaterialien, beispielsweise II-VI-Halbleitermaterialien, oder durch partielles, lithografisches Abheben, sogenanntes Lift-off-Verfahren, von zuvor abgeschiedenen keramischen Konversionsmaterialien erfolgen. Auch eine Ablation von Konversionsschichten mittels Laserbestrahlung ist möglich.

Bei einer bevorzugten Ausgestaltung der optoelektronischen Projektionsvorrichtung ist dem Halbleiterkörper auf der Strahlungsaustrittsseite ein optisches Element nachgeordnet. Insbesondere tritt so zumindest ein Teil des vom Halbleiterkörper erzeugten und durch die Strahlungsaustrittsseite des Halbleiterkörpers austretenden Lichts durch das optische Element und wird von diesem optisch beeinflusst.

Das optische Element ist vorzugsweise ein strahlungslenkendes Element, das im Strahlengang des Halbleiterkörpers zur Lenkung der von der aktiven Schicht emittierten Strahlung auf eine Projektionsfläche angeordnet ist. Das zur Projektion des von dem Halbleiterkörper emittierten Lichts auf eine Projektionsfläche bestimmte optische Element kann beispielsweise aus einer oder mehreren Linsen, insbesondere einem Linsensystem, bestehen. Die Linsen bzw. das Linsensystem kann dabei jeweils eine oder zwei gekrümmte Flächen aufweisen. Die Linse bzw. das Linsensystem kann direkt auf dem Halbleiterkörper befestigt sein. Alternativ kann die Linse bzw. das Linsensystem in einem definierten Abstand zum Halbleiterkörper angeordnet sein. Der definierte Abstand kann dabei mittels beispielsweise eines äußeren Rahmens, der den Halbleiterkörper umrahmt, erzeugt werden.

Je nach gewünschter Anwendung der Projektionsvorrichtung kann die Linse bzw. das Linsensystem so geformt sein, dass ein maßstabgerechtes Bild der von dem Halbleiterkörper emittierten Strahlung auf einer ebenen oder gekrümmten Projektionsfläche senkrecht, parallel oder diagonal zur Strahlungsaustrittsseite des Halbleiterkörpers erzeugt wird.

Gemäß einer Ausführungsform der optoelektronischen Projektionsvorrichtung umfasst die Projektionsvorrichtung ein optisches Element, das durch eine Außenfläche eines Vergusskörpers gebildet ist, der den Halbleiterkörper umgibt. Insbesondere ist der Halbleiterkörper von einem Vergussmaterial, bei dem es sich beispielsweise um ein Silikon, ein Epoxydharz oder Hybridmaterialien aus Silikon und Epoxydharz handeln kann, umgeben. Das Vergussmaterial kann den Halbleiterkörper dabei zumindest stellenweise formschlüssig umhüllen. Der Vergusskörper weist dabei eine Außenfläche auf, welche nach Art einer Projektionslinse geformt ist.

Durch die Ausbildung des Vergusskörpers als optisches Element für die Projektionsvorrichtung ermöglicht sich, dass die Projektionsvorrichtung mit Vorteil lediglich zwei Elemente aufweist. Als Bild gebendes Element findet der Halbleiterkörper Verwendung. Als Projektionsoptik kommt der Verguss des Halbleiterkörpers zum Einsatz. Durch die Linsenform des Vergusskörpers verringern sich weiter die Verluste aufgrund von Reflektionen an der Grenzfläche zwischen dem Vergusskörper und dem umgebenden Material, beispielsweise Luft. Insbesondere erhöht sich die Lichtauskopplung durch die Formgebung der Außenfläche des Vergusskörpers mit Vorteil.

Bei einer bevorzugten Ausgestaltung der Projektionsvorrichtung reflektieren die erste und/oder die zweite Kontaktschicht einen von der aktiven Schicht in Richtung zu der Rückseite hin emittierten Teil der elektromagnetischen Strahlung in Richtung der Strahlungsaustrittsseite.

Ist beispielsweise die zweite Kontaktschicht in Form von Pixeln strukturiert und reflektierend ausgebildet, so erscheint das vom Halbleiterkörper abgestrahlte Licht dort, wo sich die zweite Kontaktschicht befindet, heller als in angrenzenden Bereichen. Auf diese Weise kann ein Bild erzeugt werden, das sich dadurch auszeichnet, dass die Pixel im Bild heller dargestellt werden als die umgebenden Bereiche.

Bei einer bevorzugten Ausgestaltung ist die Projektionsvorrichtung Bestandteil eines elektronischen Bauelements, insbesondere eines Mobiltelefons, PDAs, Laptops, Computers, einer Uhr oder eines Weckers.

Bevorzugt ist das elektronische Bauelement ein tragbares Bauelement. Ein tragbares Bauelement zeichnet sich insbesondere dadurch aus, dass es besonders Platz sparend ausgebildet ist. Insbesondere weist das Bauelement eine möglichst geringe Bauelementgröße auf.

Besonders bevorzugt weist das elektronische Bauelement eine Projektionsfläche auf. Die Projektionsfläche ist somit insbesondere innerhalb des elektronischen Bauelements ausgebildet. Das im Betrieb der Projektionsvorrichtung erzeugte Bild kann mittels einer Rückprojektion auf die Projektionsfläche innerhalb des elektronischen Bauelements abgebildet werden.

Alternativ kann die Projektionsfläche außerhalb des elektronischen Bauelements liegen. In diesem Fall kann die Projektionsfläche beispielsweise ein Tisch, eine Wand oder ein Gehäuseteil des elektronischen Bauelements sein.

Weitere Merkmale, Vorteile, bevorzugte Ausgestaltungen und Zweckmäßigkeiten der optoelektronischen Projektionsvorrichtung ergeben sich aus den im Folgenden in Verbindung mit den Figuren 1 bis 3 erläuterten Ausführungsbeispielen.

Es zeigen:
- Figur 1A bis 1F: jeweils einen schematischen Querschnitt eines Ausführungsbeispiels einer erfindungsgemäßen Projektionsvorrichtung,
- Figuren 2A bis 2C: jeweils eine schematische Draufsicht weiterer Ausführungsbeispiele jeweils einer erfindungsgemäßen Projektionsvorrichtung, und
- Figur 3: einen schematischen Querschnitt eines Ausführungsbeispiels eines elektronischen Bauelements mit darin angeordneter erfindungsgemäßen Projektionsvorrichtung.

Gleiche oder gleich wirkende Bestandteile sind jeweils mit den gleichen Bezugszeichen versehen. Die dargestellten Bestandteile sowie die Größenverhältnisse der Bestandteile untereinander sind nicht als maßstabsgerecht anzusehen.

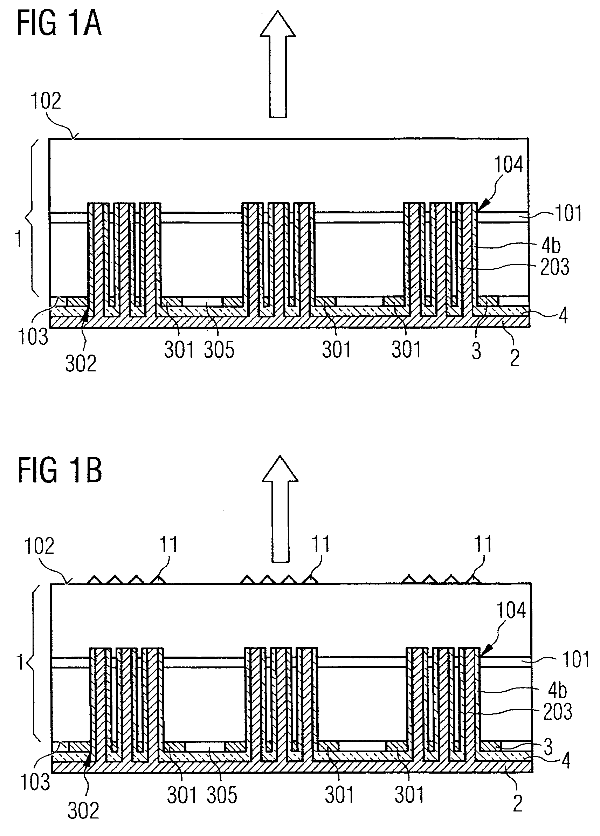

Die Figuren 1A bis 1F zeigen jeweils einen schematischen Querschnitt einer Projektionsvorrichtung, die einen Halbleiterkörper 1 aufweist. Bei dem Halbleiterkörper 1 handelt es sich beispielsweise um einen Leuchtdiodenchip oder einen Laserdiodenchip. Der Halbleiterkörper 1 ist bevorzugt in Dünnfilmbauweise ausgeführt und umfasst epitaktisch abgeschiedene Schichten, die den Halbleiterkörper 1 bilden.

Die Schichten des Halbleiterbauelements basieren bevorzugt auf einem III/V-Verbindungshalbleitermaterial. Ein III/V-Verbindungshalbleitermaterial weist wenigstens ein Element aus der dritten Hauptgruppe, wie beispielsweise Al, Ga, In und ein Element aus der fünften Hauptgruppe, wie beispielsweise N, P, As auf. Insbesondere umfasst der Begriff III/V-Verbindungshalbleitermaterial die Gruppe der binären, ternären und quaternären Verbindungen, die wenigstens ein Element aus der dritten Hauptgruppe und wenigstens ein Element aus der fünften Hauptgruppe enthalten, insbesondere Nitrid- und Phosphidverbindungshalbleiter. Eine solche binäre, ternäre oder quaternäre Verbindung kann zudem beispielsweise einen oder mehrere Dotierstoffe sowie zusätzliche Bestandteile aufweisen.

Der Halbleiterkörper 1 weist eine zur Erzeugung von elektromagnetischer Strahlung geeignete aktive Schicht 101 auf. Die aktive Schicht 101 umfasst bevorzugt einen pn-Übergang, eine Doppelheterostruktur, einen Einfachquantentopf oder eine Mehrfachquantentopfstruktur zur Strahlungserzeugung. Bevorzugt emittiert die aktive Schicht 101 des Halbleiterkörpers 1 Strahlung im ultravioletten oder infraroten oder besonders bevorzugt im sichtbaren Wellenlängenbereich. Dazu kann die aktive Schicht 101 des Halbleiterkörpers 1 beispielsweise InGaAlP oder InGaN aufweisen.

Der Halbleiterkörper 1 weist ferner eine Strahlungsaustrittsseite 102 auf, an der die in der aktiven Schicht 101 erzeugte elektromagnetische Strahlung aus dem Halbleiterkörper 1 austritt.

Der Halbleiterkörper 1 ist ein Bild gebendes Element der Projektionsvorrichtung. Insbesondere wird das von der Projektionsvorrichtung im Betrieb erzeugte Bild nicht von einem weiteren Element, wie beispielsweise einer Schablone, einem Dia oder einem Lichtmodulator, erzeugt, sondern der Halbleiterkörper 1 selbst ist das Bild gebende Element der Projektionsvorrichtung. Eine Platz sparende Projektionsvorrichtung ermöglicht sich so mit Vorteil.

An einer der Strahlungsaustrittsseite 102 des Halbleiterkörpers 1 gegenüberliegenden Rückseite 103 sind zur elektrischen Kontaktierung des Halbleiterkörpers 1 eine erste Kontaktschicht 2 und eine zweite Kontaktschicht 3 angeordnet und mittels einer Trennschicht 4 elektrisch voneinander isoliert.

Bevorzugt ist die zweite Kontaktschicht 3 in Form von Pixeln 301 strukturiert, wobei sich im Betrieb der Projektionsvorrichtung durch die Projektion der Pixel 301 zumindest ein Teil des vorgegebenen Bildes 10 ergibt. Beispielsweise können die Pixel 301 der zweiten Kontaktschicht 3 in einer zweidimensionalen Segment-Anzeige, insbesondere einer Sieben-Segment-Anzeige, oder in einer zweidimensionalen regelmäßigen Matrix aus n Zeilen und m Spalten strukturiert sein.

Alternativ kann die zweite Kontaktschicht 3 zumindest eine Struktur in Form eines Piktogramms, Zeichens, Buchstabens oder Schriftzuges aufweisen. Bevorzugt weist die zweite Kontaktschicht 3 eine Mehrzahl von Strukturen in Form eines Piktogramms, Zeichens, Buchstabens oder Schriftzuges auf.

Bevorzugt sind Bereiche 305 der zweiten Kontaktschicht 3, die zwischen den Pixeln 301 angeordnet sind, elektrisch isolierend ausgebildet. Insbesondere sind die Pixel 301 mittels der Bereiche 305 voneinander elektrisch isoliert.

Bevorzugt ist die elektrische Leitfähigkeit der Bereiche 305 der zweiten Kontaktschicht 3 außerhalb der Pixel 301 zerstört oder zumindest reduziert. Alternativ kann die zweite Kontaktschicht 3 außerhalb der Pixel 301 bereichsweise entfernt sein. In diesem Fall ist zwischen den Pixeln 301 elektrisch isolierendes Material, beispielsweise dielektrisches Material, angeordnet.

Die erste Kontaktschicht 2 ist bevorzugt an der von dem Halbleiterkörper 1 abgewandten Seite der zweiten Kontaktschicht 3 angeordnet. Vorzugsweise ist zwischen der ersten Kontaktschicht 2 und der zweiten Kontaktschicht 3 eine elektrisch isolierende Trennschicht 4 angeordnet.

Die zweite Kontaktschicht 3 und die elektrisch isolierende Trennschicht 4 weisen vorzugsweise eine Mehrzahl von Öffnungen 302 auf, durch die die erste Kontaktschicht 2 zu dem Halbleiterkörper 1 verläuft. Der Teilbereich 203 der ersten Kontaktschicht 2, der durch die Öffnungen 302 führt, erstreckt sich von der Rückseite 103 des Halbleiterkörpers 1 durch einen Durchbruch 104 der aktiven Schicht 101 hindurch in Richtung zu der Strahlungsaustrittsseite 102 hin. Die erste Kontaktschicht 2 ist somit zur elektrischen Kontaktierung des Halbleiterkörpers 1 an einer der Strahlungsaustrittsseite 102 zugewandten Seite der aktiven Schicht 101 geeignet. Die zweite Kontaktschicht 3 ist zur elektrischen Kontaktierung des Halbleiterkörpers 1 von seiner Rückseite 103 geeignet.

Die erste Kontaktschicht 2 ist in diesem Ausführungsbeispiel somit mit der epitaktischen Schicht des Halbleiterkörpers 1 über elektrisch isolierte Öffnungen bzw. Durchbrüche punktuell verbunden. Insbesondere sind die Teilbereiche 203 der ersten Kontaktschicht 2, die durch die Öffnungen 302 der zweiten Kontaktschicht 3 und durch den Halbleiterkörper 1 geführt sind, von der ersten Kontaktschicht 3 und den Schichten des Halbleiterkörpers 1 elektrisch isoliert geführt. Dies kann beispielsweise durch die elektrisch isolierende Trennschicht 4b realisiert werden.

Die erste und/oder zweite Kontaktschicht 2, 3 können ein Metall oder eine Metalllegierung enthalten. Die elektrisch isolierende Trennschicht 4 kann beispielsweise dielektrische Schichten enthalten.

Die erste Kontaktschicht 2 ist vorzugsweise als flächiger Spiegel ausgebildet, der sich nahezu über die gesamte laterale Ausdehnung des Halbleiterkörpers 1 erstreckt. Vorzugsweise ist die erste Kontaktschicht 2 als n-Kontakt des Halbleiterkörpers 1 ausgebildet.

Die zweite Kontaktschicht 3 ist bevorzugt auf Teilbereichen des Halbleiterkörpers 1 angeordnet. Die zweite Kontaktschicht 3 erstreckt sich somit nicht über die gesamte laterale Ausdehnung des Halbleiterkörpers 1. Vorzugsweise ist die zweite Kontaktschicht 3 als p-Kontakt des Halbleiterkörpers 1 ausgebildet.

Bevorzugt sind die erste und/oder die zweite Kontaktschicht 2, 3 für die von der aktiven Schicht 101 emittierte Strahlung reflektierend ausgebildet.

Besonders bevorzugt ist die zweite Kontaktschicht 3 reflektierend ausgebildet. Dadurch erhöht sich in den Bild gebenden Breichen des Halbleiterkörpers die Strahlungsauskopplung, wodurch sich bevorzugt in diesen Bereichen die Strahlungseffizienz erhöht.

In den Ausführungsbeispielen der Figuren 1A bis 1F weist die erste Kontaktschicht 2 einen elektrischen Anschlussbereich auf, der zur elektrischen Kontaktierung des Halbleiterkörpers 1 geeignet ist (nicht dargestellt). Die zweite Kontaktschicht 3 weist bevorzugt eine Mehrzahl von elektrischen Anschlussflächen auf (nicht dargestellt), wobei jeweils ein Pixel 301 mit einer Anschlussfläche elektrisch leitend verbunden ist. Die Pixel 301 der zweiten Kontaktschicht 3 sind somit durch die Mehrzahl von elektrischen Anschlussflächen getrennt voneinander elektrisch ansteuerbar.

Durch die zu Pixeln strukturierte zweite Kontaktschicht 3 wird im Betrieb der Projektionsvorrichtung das abzubildende Bild der Projektionsvorrichtung direkt durch eine lateral selektive Emission im Halbleiterkörper 1 generiert. Durch eine geeignete Ansteuerung der Pixel 301 der zweiten Kontaktschicht 3 können so unterschiedliche Muster erzeugt werden. Insbesondere können durch eine entsprechende Ansteuerung verschieden leuchtende Bilder, wie beispielsweise Piktogramme, Buchstaben und/oder Schriftzüge, generiert und über ein Linsensystem auf eine Projektionsfläche abgebildet werden.

Mit Vorteil kann so ein einziger Halbleiterkörper 1 im Betrieb der Projektionsvorrichtung mehrere vorgegebene Bilder darstellen, welche insbesondere unabhängig voneinander erzeugt werden können. Eine flexibel einsetzbare Projektionsvorrichtung ermöglicht sich mit Vorteil.

Figur 1B zeigt einen schematischen Querschnitt einer weiteren Projektionsvorrichtung. Zusätzlich zu dem in Figur 1A dargestellten Ausführungsbeispiel sind auf der Strahlungsaustrittsseite 102 des Halbleiterkörpers 1 Strahlungsauskoppelstrukturen 11 ausgebildet. Insbesondere sind die Strahlungsauskoppelstrukturen 11 bereichsweise auf der Strahlungsaustrittsseite 102 angeordnet.

Insbesondere sind lediglich auf den Bereichen der Strahlungsaustrittsseite 102 des Halbleiterkörpers 1, unterhalb derer in vertikaler Richtung ein Pixel 301 der zweiten Kontaktschicht 3 angeordnet ist, Strahlungsauskoppelstrukturen 11 angeordnet. In diesem Fall verbessert sich die Strahlungsauskopplung der von dem Halbleiterköper 1 emittierten Strahlung in ausgewählten Bereichen des Halbleiterkörpers 1, welche vertikal über der zweiten Kontaktschicht 3, insbesondere über den Pixeln 301 der zweiten Kontaktschicht 3, angeordnet sind. Diese ausgewählten Bereiche der Strahlungsaustrittsseite 102 entsprechen den Bereichen des Halbleiterkörpers 1, die für die Bildung des vorgegebenen Bildes 10 verantwortlich sind.

Mit Vorteil verbessert sich in Bereichen der Strahlungsaustrittsseite 102, die Strahlungsauskoppelstrukturen 11 aufweisen, die Auskopplung der von dem Halbleiterkörper 1 emittierten Strahlung, wodurch sich die Effizienz des Halbleiterkörpers 1 mit Vorteil steigert.

An der Grenzfläche des Halbleiterkörpers 1 erfolgt ein Sprung des Brechungsindex von dem Material des Halbleiterkörpers 1 einerseits zu dem umgebenden Material andererseits. Dadurch kommt es zu einer Brechung des Lichts beim Übergang vom Halbleiterkörper 1 in die Umgebung. Je nach Winkel, in dem ein Lichtstrahl auf die Grenzfläche auftrifft, kann es zur Totalreflektion kommen. Aufgrund der parallelen Oberflächen des Halbleiterkörpers 1 trifft der reflektierte Lichtstrahl im gleichen Winkel auf der gegenüber liegenden Grenzfläche auf, so dass auch dort Totalreflektion auftritt. Die Folge ist, dass der Lichtstrahl somit nichts zur Lichtabstrahlung beitragen kann. Dadurch, dass auf der Strahlungsaustrittsseite 102 Strahlungsauskoppelstrukturen 11 angeordnet sind, wird der Winkel verändert, in dem ein Lichtstrahl auf die Oberfläche auftrifft.

Unter Strahlungsauskoppelstrukturen 11 sind vor allem Oberflächenstrukturierungen zu verstehen. Insbesondere kann eine verbesserte Lichtauskopplung etwa durch ein Höhenprofil der Strahlungsaustrittsseite 102, beispielsweise eine Mikroprismenstrukturierung, oder eine Rauhigkeitserhöhung der Strahlungsaustrittsseite 102 ermöglicht werden. Sind Aufrauungen der Strahlungsaustrittsseite 102 vorgesehen, ist dadurch eine unregelmäßige Oberfläche gebildet, die die Auskopplung von Licht verbessert.

Im Übrigen stimmt das Ausführungsbeispiel der Figur 1B mit dem Ausführungsbeispiel der Figur 1A überein.

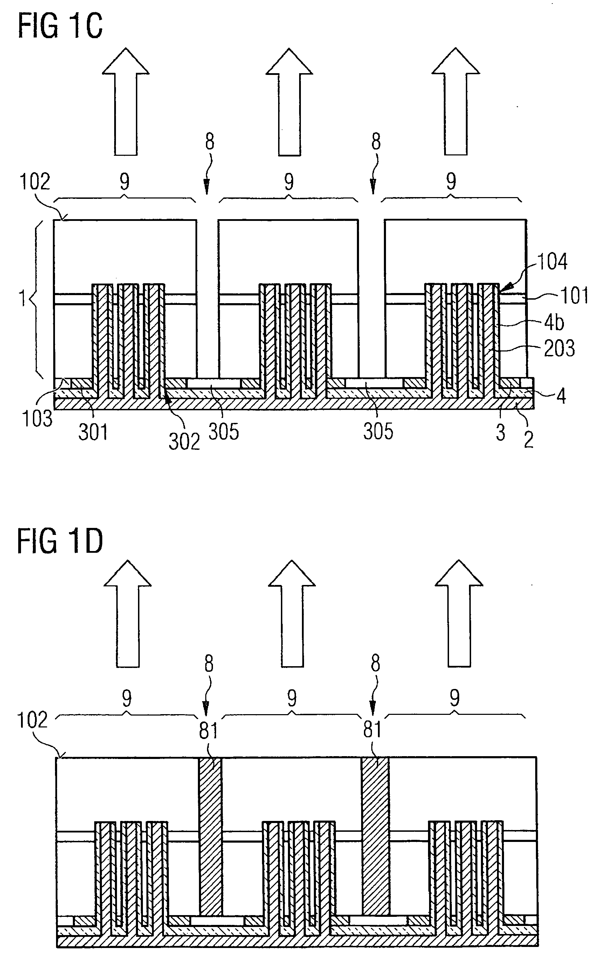

Figur 1C zeigt einen schematischen Querschnitt einer weiteren Projektionsvorrichtung. Im Unterschied zu dem Ausführungsbeispiel der Figur 1A ist der Halbleiterkörper 1 zu einem Muster strukturiert, wobei sich im Betrieb der Projektionsvorrichtung durch die Projektion des Musters zumindest ein Teil des vorgegebenen Bildes 10 ergibt.

Vorzugsweise ergibt sich durch die Projektion des Musters des Halbleiterkörpers 1 das vollständige vorgegebene Bild 10.

Die Strukturierung des Halbleiterkörpers 1 zu einem Muster kann dabei beispielsweise durch ein Ätzverfahren erfolgen, wobei das zu erzeugende Muster 10 durch ein lithografisches Verfahren definiert wird. Beispielsweise kann der Halbleiterkörper dazu stellenweise vollständig entfernt sein. Das als Bild 10 darzustellende Muster entsteht so durch die Bereiche der Strahlungsaustrittsseite 102 des Halbleiterkörpers 1, welche nach Fertigstellung des Halbleiterkörpers 1, insbesondere nach erfolgter Strukturierung des Halbleiterkörpers 1, im Betrieb Licht emittieren.

Soll beispielsweise von der optoelektronischen Projektionsvorrichtung ein Streifenmuster als Bild dargestellt werden, so kann der Halbleiterkörper 1 bereichsweise vollständig entfernt werden, insbesondere in Figur 1C als entfernte Bereiche 8 dargestellt. Im Betrieb des Halbleiterkörpers 1 leuchten dann nunmehr die streifenförmigen Bereiche 9. Der Halbleiterkörper 1 ist dabei das Bild gebende Element, wobei das Muster durch die Streifen gebildet ist.

Bei dieser Ausgestaltung ist mit Vorteil die Lichterzeugung auf die selektiv leuchtenden Bereiche des Halbleiterkörpers 1 konzentriert.

Im Übrigen stimmt das Ausführungsbeispiel der Figur 1C mit dem Ausführungsbeispiel der Figur 1A überein.

Figur 1D zeigt einen schematischen Querschnitt einer weiteren Projektionsvorrichtung. Im Unterschied zu dem Ausführungsbeispiel der Figur 1C sind die entfernten Bereiche 8 sind mit einem reflektierenden Material 81 gefüllt. Als reflektierende Materialien 81 kommen beispielsweise Metalle, zum Beispiel Ag, oder Materialien mit niedrigem Brechungsindex, zum Beispiel SiO₂, in Betracht. Dadurch kann Strahlung, die von den einzelnen streifenförmigen Bereichen 9 in Richtung der jeweiligen benachbarten streifenförmigen Bereiche 9 emittiert wird, an dem reflektierenden Materialien 81 in Richtung Strahlungsaustrittsseite 102 reflektiert und dort ausgekoppelt werden. Insbesondere verbessert sich so die Effizienz der Projektionsvorrichtung mit Vorteil.

Zusätzlich kann ein optisches Übersprechen zwischen den einzelnen Bereichen 9 mit Vorteil verhindert werden. Durch das reflektierende Material 81 verbessert so mit Vorteil der Kontrast der Projektionsvorrichtung sowie die Effizienz der Projektionsvorrichtung.

Im Übrigen stimmt das Ausführungsbeispiel der Figur 1D mit dem Ausführungsbeispiel der Figur 1C überein.

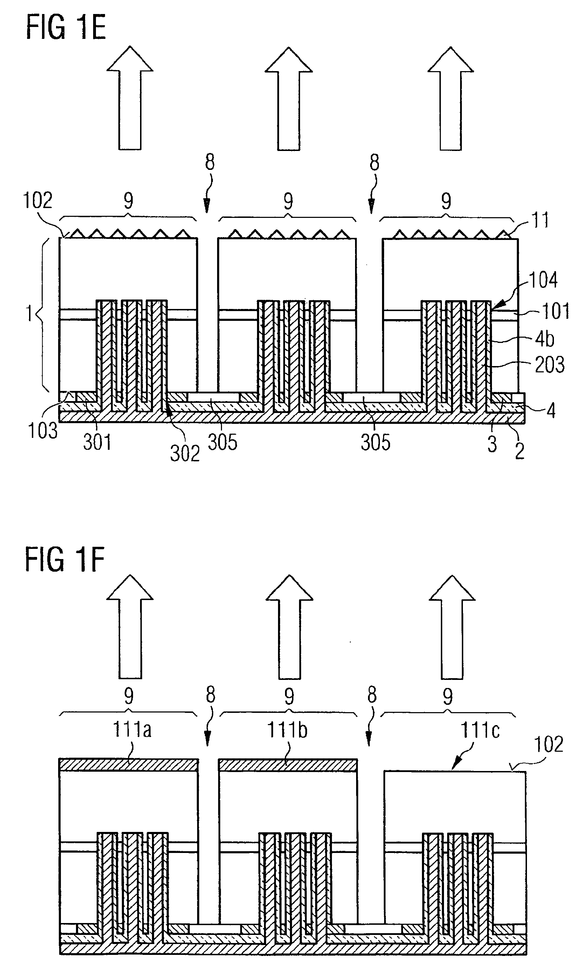

Figur 1E stellt ein weiteres Ausführungsbeispiel einer weiteren Projektionsvorrichtung dar. Im Unterschied zu dem in Figur 1C dargestellten Ausführungsbeispiel sind auf dem in Figur 1E gezeigten Ausführungsbeispiel Strahlungsauskoppelstrukturen 11 auf der Strahlungsaustrittsseite 102 angeordnet. Dabei sind die Strahlungsauskoppelstrukturen 11 in den Bereichen 9 der Strahlungsaustrittsseite 102 des Halbleiterkörpers angeordnet, unterhalb derer in vertikaler Richtung ein Pixel 301 der zweiten Kontaktschicht 3 angeordnet ist.

Die Strahlungsauskoppelstrukturen 11 verbessert mit Vorteil die Auskopplung der von dem Halbleiterkörper 1 emittierten Strahlung, wodurch sich die Effizienz des Halbleiterkörpers 1 mit Vorteil steigert.

Im Übrigen stimmt das Ausführungsbeispiel der Figur 1E mit dem Ausführungsbeispiel der Figur 1C überein.

Figur 1F stellt ein weiteres Ausführungsbeispiel einer weiteren Projektionsvorrichtung dar. Im Unterschied zu dem in Figur 1E dargestellten Ausführungsbeispiel sind auf der Strahlungsaustrittsseite 102 anstelle der Strahlungsauskoppelstrukturen Wellenlängen-Konversionselemente 111 angeordnet. Beispielsweise ist auf einem ersten Bereich 9 des Halbleiterkörpers ein grün emittierendes Konversionselement 111a, auf einem zweiten Bereich 9 des Halbleiterkörpers ein rot emittierendes Konversionselement 111b und auf einem dritten Bereich 9 des Halbleiterkörpers kein Konversionselement im Bereich 111c angeordnet. Dadurch kann mit Vorteil ein vollfarbiger Halbleiterkörper erzeugt werden, welcher in der Projektionsvorrichtung vollfarbige Bilder projizieren kann.

Im Übrigen stimmt das Ausführungsbeispiel der Figur 1F mit dem Ausführungsbeispiel der Figur 1E überein.

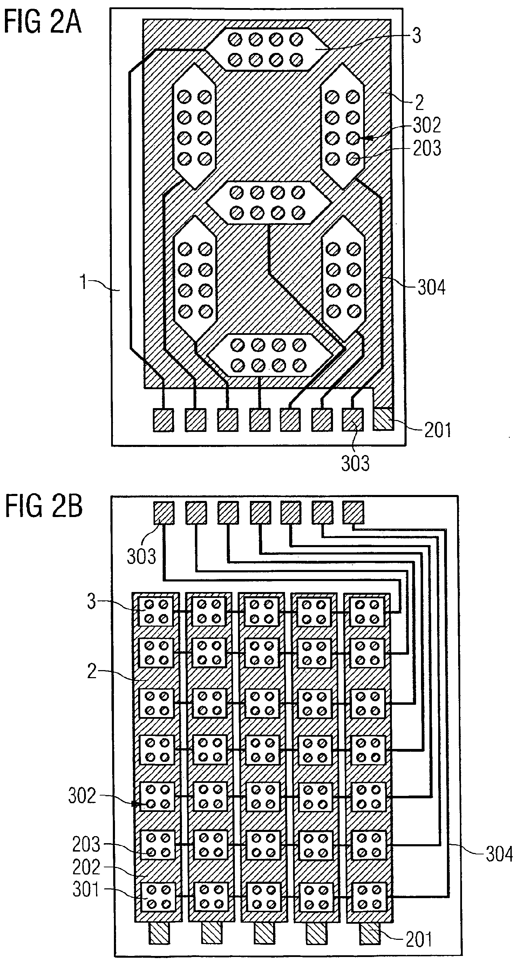

In den Figuren 2A bis 2C sind jeweils Längsschnitte entlang einer lateralen Ausdehnung einer Projektionsvorrichtung gezeigt. Insbesondere sind die erste Kontaktschicht 2 und die zweite Kontaktschicht 3 detailliert dargestellt.

In diesem Ausführungsbeispiel der Figur 2A ist die erste Kontaktschicht 2 ganzflächig ausgebildet. Insbesondere erstreckt sich die erste Kontaktschicht 2 nahezu über die gesamte laterale Ausdehnung des Halbleiterkörpers 1.

Die erste Kontaktschicht 2 weist einen elektrischen Anschlussbereich 201 auf. Dieser Anschlussbereich 201 ist zur elektrischen Kontaktierung des Halbleiterkörpers 1 an seiner Strahlungsaustrittsseite geeignet.

Die zweite Kontaktschicht 3 ist in Form von Pixeln 301 strukturiert ausgebildet. In dem Ausführungsbeispiel der Figur 2A sind die Pixel 301 der zweiten Kontaktschicht 3 in einer zweidimensionalen Sieben-Segment-Anzeige angeordnet. Eine Sieben-Segment-Anzeige eignet sich insbesondere zur Darstellung von Zahlen von 0 bis 9.

Die zweite Kontaktschicht 3 des Ausführungsbeispiels der Figur 2A ist, wie in dem Ausführungsbeispiel der Figur 1 dargestellt, zwischen der ersten Kontaktschicht 2 und dem Halbleiterkörper 1 angeordnet.

Der Übersicht halber ist jeweils in den Ausführungsbeispielen der Figuren 2A bis 2C die Anordnung der ersten Kontaktschicht 2, der zweiten Kontaktschicht 3 und des Halbleiterkörpers 1 so dargestellt, dass insbesondere die zweite Kontaktschicht 3 gezeigt ist.

Die zweite Kontaktschicht 3 weist eine Mehrzahl von elektrischen Anschlussflächen 303 auf. In diesem Ausführungsbeispiel weist die zweite Kontaktschicht 3 sieben elektrische Anschlussflächen 303 auf. Jeweils ein Pixel 301 der zweiten Kontaktschicht 3 ist mit einer Anschlussfläche 303 elektrisch leitend verbunden. Insbesondere ist jedes Pixel 301 über eine unter den Pixeln 301 angeordnete Leiterbahn 304 separat mit jeweils einer elektrischen Anschlussfläche 303 verbunden.

Teilbereiche 203 der ersten Kontaktschicht 2 sind durch Öffnungen 302 der zweiten Kontaktschicht 3 geführt. Insbesondere sind die Teilbereiche 203 der ersten Kontaktschicht 2 elektrisch von der zweiten Kontaktschicht 3 isoliert durch die Öffnungen 302 der zweiten Kontaktschicht 3 geführt. Wie in Figur 1 dargestellt, führen die Teilbereiche 203 der ersten Kontaktschicht 2 elektrisch isoliert durch Öffnungen der zweiten Kontaktschicht 3 und durch Durchbrüche der aktiven Schicht 101.

Zur elektrischen Isolierung der ersten und zweiten Kontaktschicht 2, 3 voneinander ist eine elektrisch isolierende Trennschicht zwischen der ersten Kontaktschicht 2 und der zweiten Kontaktschicht 3 angeordnet (nicht dargestellt).

Die erste Kontaktschicht 2 weist zur elektrischen Kontaktierung einen elektrischen Anschlussbereich 201 auf.

Alternativ besteht die Möglichkeit, dass die erste Kontaktschicht 2 keinen solchen elektrisch leitenden Anschlussbereich 201 aufweist, sondern direkt elektrisch leitend mit einem elektrisch leitfähigen Träger verbunden ist (nicht dargestellt). Ein solcher Träger ermöglicht somit die Kontaktierung der Kontaktschicht 2 von der Rückseite 103 aus.

In Figur 2B ist ein weiterer Längsschnitt eines Ausführungsbeispiels einer Projektionsvorrichtung gezeigt. In diesem Ausführungsbeispiel ist die erste Kontaktschicht 2 in Form von Strukturen 202, insbesondere streifenförmig, strukturiert. Die erste Kontaktschicht 2 ist demnach nicht ganzflächig ausgebildet, sondern weist elektrisch voneinander isolierte Strukturen 202 auf.

Ferner weist die erste Kontaktschicht 2 eine Mehrzahl von elektrischen Anschlussbereichen 201 auf. Jeweils eine Struktur 202 der ersten Kontaktschicht 2 ist mit einem elektrischen Anschlussbereich 201 elektrisch leitend verbunden. Die Strukturen 202 der ersten Kontaktschicht 2 sind somit separat voneinander jeweils über einen elektrischen Anschlussbereich 201 elektrisch ansteuerbar.

Die zweite Kontaktschicht 3 ist in Form von Pixeln 201 strukturiert, wobei die Pixel 301 in einer zweidimensionalen regelmäßigen Matrix aus n Zeilen und m Spalten angeordnet sind. Die Pixel 301 sind insbesondere auf den streifenförmigen Strukturen 202 der ersten Kontaktschicht 2 angeordnet. Insbesondere sind die Pixel 301, die sich jeweils in einer gemeinsamen Reihe befinden, gemeinsam über jeweils eine Leiterbahn 304 mit einer elektrisch leitenden Anschlussfläche 303 elektrisch leitend verbunden. Insbesondere weist die zweite Kontaktschicht 3 bei einer Matrixanordnung der Pixel 301 mit n Zeilen n elektrische Anschlussflächen 303 auf. Dadurch, dass die Pixel 301 zeilenweise jeweils separat mit einer elektrischen Anschlussfläche 303 der zweiten Kontaktschicht und spaltenweise separat mit jeweils einem elektrischen Anschlussbereich 201 der ersten Kontaktschicht 2 elektrisch leitend verbunden sind, ist jedes Pixel 301 separat elektrisch ansteuerbar.

Wird beispielsweise lediglich eine Spalte der ersten Kontaktschicht 2 und lediglich eine Zeile der zweiten Kontaktschicht 3 elektrisch leitend angesteuert, so ist lediglich ein Pixel 301 elektrisch kontaktiert. Eine Verschaltung von einzeln elektrisch voneinander ansteuerbaren Pixeln 301 auf der Rückseite des Halbleiterkörpers 1 ermöglicht sich dadurch. Durch eine entsprechende Ansteuerung der einzelnen Pixel 301 auf dem Halbleiterkörper 1 können so verschieden leuchtende Bilder, wie beispielsweise Piktogramme, Buchstabe und/oder Schriftzüge, generiert und über eine Linse oder ein Linsensystem auf eine nahe gelegte Projektionsfläche abgebildet werden. Eine Projektionsvorrichtung, die flexible Bilder projizieren kann, ermöglicht sich mit Vorteil.

Wie in dem Ausführungsbeispiel zu Figur 2A führen Teilbereiche 203 der ersten Kontaktschicht 2 elektrisch isoliert durch die zweite Kontaktschicht 3 und durch den Halbleiterkörper zur Strahlungsaustrittsseite des Halbleiterkörpers 1.

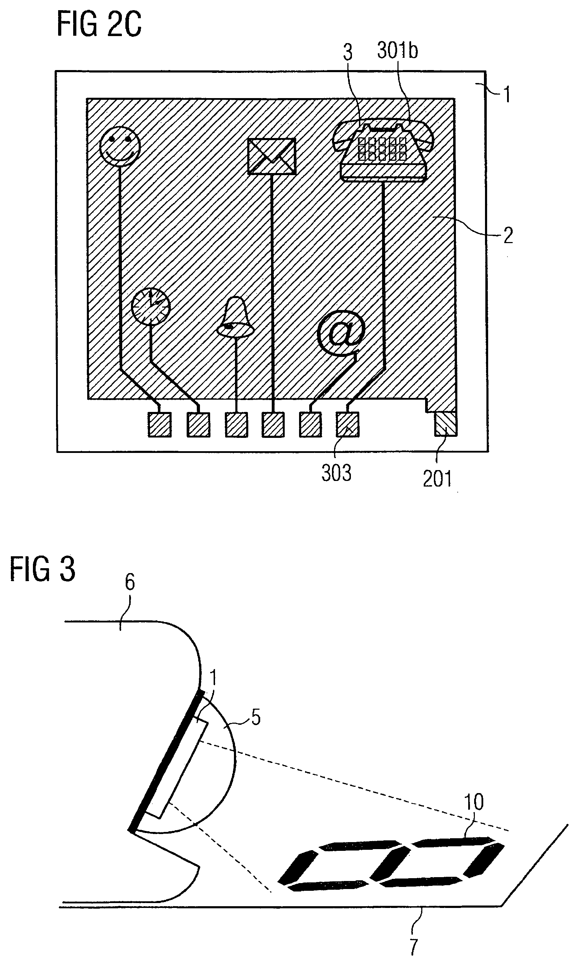

In Figur 2C ist ein weiteres Ausführungsbeispiel einer Projektionsvorrichtung gezeigt.

Wie in dem Ausführungsbeispiel zu Figur 2A ist in diesem Ausführungsbeispiel der Figur 2C die erste Kontaktschicht 2 ganzflächig ausgebildet. Im Gegensatz zu dem Ausführungsbeispiel der Figur 2A weist die zweite Kontaktschicht 3 Strukturen 301b jeweils in Form eines Piktogramms bzw. Zeichens auf. Jeweils eine Struktur 301b ist über jeweils eine Leiterbahn 304 mit einer elektrischen Anschlussfläche 303 der zweiten Kontaktschicht 3 elektrisch leitend verbunden. Jede Struktur 301b der zweiten Kontaktschicht 3 ist somit separat elektrisch ansteuerbar.

Die Anordnung der elektrischen Anschlussflächen 303 an der Rückseite des Halbleiterkörpers 1 bietet den Vorteil, dass dadurch eine Mehrzahl von Halbleiterkörpern 1 dicht nebeneinander angeordnet werden können und sich somit die Projektion von mehreren Zeichen, Zeichenketten oder Schriftzügen ermöglicht. In diesem Fall kann ein separates Linsensystem bzw. eine separate Linse pro Halbleiterkörper 1 oder ein gemeinsames Linsensystem bzw. eine gemeinsame Linse für alle Halbleiterkörper 1 zum Einsatz kommen.

In dem Ausführungsbeispiel der Figur 3 ist eine Projektionsvorrichtung dargestellt, die einen Halbleiterkörper 1, ein optisches Element 5 und eine Projektionsfläche 7 zeigt. Die Projektionsvorrichtung des Ausführungsbeispiels der Figur 3 ist Bestandteil eines elektronischen Bauelements 6, beispielsweise eines Mobiltelefons, Laptops, PDAs, Computers, Uhr oder Weckers. Vorzugsweise ist das elektronische Bauelement 6 ein tragbares Bauelement.

Die Projektionsfläche 7 kann Bestandteil des elektronischen Bauelements 6 sein, beispielsweise durch ein Gehäuseteil des Bauelements gebildet sein, oder außerhalb des Bauelements 6 liegen, beispielsweise durch einen Tisch oder eine Wand gebildet sein. Durch die in dem elektronischen Bauelement integrierte Projektionsvorrichtung kann mit Vorteil auf nahe liegende Flächen Licht in bestimmten Bildern, wie beispielsweise Piktogramme, Buchstaben und/oder Schriftzüge, projiziert werden.

Das zur Projektion des vom Halbleiterkörpers 1 emittierten Lichts auf eine Projektionsfläche 7 bestimmte Linsensystem bzw. die Linse 5 kann aus einer oder mehreren Linsen bestehen, die jeweils vorzugsweise eine oder zwei gekrümmte Flächen aufweisen. Dabei kann das Linsensystem bzw. die Linse 5 direkt auf dem Halbleiterkörper 1 befestigt sein oder durch einen äußeren Rahmen in einem definierten Abstand zum Halbleiterkörper 1 gehalten werden. Das Linsensystem bzw. die Linse 5 kann dabei so geformt sein, dass je nach gewünschter Anwendung ein maßstabsgerechtes Abbild des emittierten Lichtmusters auf einer ebenen oder gekrümmten Fläche senkrecht, parallel oder diagonal zur Lichtaustrittsseite des Halbleiterkörpers 1 erscheint. Die Projektionsfläche 7 kann innerhalb des elektronischen Bauelements 6 mittels Rückprojektion oder außerhalb dessen liegen. Eine miniaturisierte Projektionsvorrichtung, die flexibel einsetzbar ist und verschiedene Bilder projizieren kann, ermöglicht sich so mit Vorteil.

## Patentansprüche

1. Optoelektronische Projektionsvorrichtung, die im Betrieb ein vorgegebenes Bild (10) erzeugt, umfassend einen Halbleiterkörper (1), der eine zur Erzeugung von elektromagnetischer Strahlung geeignete aktive Schicht (101) und eine Strahlungsaustrittsseite (102) aufweist, wobei zur elektrischen Kontaktierung des Halbleiterkörpers (1) eine erste Kontaktschicht (2) und eine zweite Kontaktschicht (3) an einer der Strahlungsaustrittsseite (102) gegenüberliegenden Rückseite (103) des Halbleiterkörpers (1) angeordnet und mittels einer Trennschicht (4) elektrisch voneinander isoliert sind, und
wobei sich ein Teilbereich (203) der ersten Kontaktschicht (2) von der Rückseite (103) durch mindestens einen Durchbruch (104) der aktiven Schicht (101) hindurch in Richtung zu der Strahlungsaustrittsseite (102) hin erstreckt,
**dadurch gekennzeichnet, dass**
der Halbleiterkörper (1) ein Bild gebendes Element der Projektionsvorrichtung ist und die zweite Kontaktschicht (3) in Form von Pixeln (301) strukturiert ist, wobei sich im Betrieb der Projektionsvorrichtung durch die Projektion der Pixel (301) zumindest ein Teil des vorgegebenen Bildes (10) ergibt.

2. Optoelektronische Projektionsvorrichtung nach Anspruch 1,
wobei
wobei die erste Kontaktschicht (2) an der von dem Halbleiterkörper (1) abgewandten Seite der zweiten Kontaktschicht (3) angeordnet ist, die zweite Kontaktschicht (3) und die elektrisch isolierende Trennschicht (4) pro Pixel (301) eine Mehrzahl von Öffnungen (302) aufweist, und die erste Kontaktschicht (2) durch die Öffnungen (302) zu dem Halbleiterkörper (1) verläuft, und
wobei die Strahlungsaustrittsseite (102) des Halbleiterkörpers (1) frei von elektrischen Anschlussstellen ist.

3. Optoelektronische Projektionsvorrichtung nach Anspruch 2,
wobei
die Pixel (301) in einer zweidimensionalen Segment-Anzeige angeordnet sind.

4. Optoelektronische Projektionsvorrichtung nach Anspruch 2,
wobei
die Pixel (301) in einer zweidimensionalen regelmäßigen Matrix aus n Zeilen und m Spalten angeordnet sind.

5. Optoelektronische Projektionsvorrichtung nach Anspruch 1,
wobei
die zweite Kontaktschicht (3) zumindest eine Struktur (301b) in Form eines Piktogramms, Zeichens, Buchstabens oder Schriftzugs aufweist.

6. Optoelektronische Projektionsvorrichtung nach einem der vorhergehenden Ansprüche, wobei
die aktive Schicht (101) eine sich über alle Pixel (301) ersteckende, durchgehende und zusammenhängende Schicht ist.

7. Optoelektronische Projektionsvorrichtung nach einem der vorhergehenden Ansprüche, wobei
der Halbleiterkörper (1) inklusive aktiver Schicht (101) zu einem Muster strukturiert ist, wobei sich im Betrieb der Projektionsvorrichtung durch die Projektion des Musters zumindest ein Teil des vorgegebenen Bildes (10) ergibt.

8. Optoelektronische Projektionsvorrichtung nach dem vorhergehenden Anspruch, wobei
der Halbleiterkörper (1) bereichsweise vollständig entfernt ist und hierdurch entfernte Bereiche (8) resultieren,
wobei die entfernten Bereiche (8) mit einem reflektierenden Material (81) gefüllt sind und die erste Kontaktschicht (2) als flächiger Spiegel ausgebildet ist, der sich in lateraler Richtung über alle Pixel (301) erstreckt.

9. Optoelektronische Projektionsvorrichtung nach einem der vorhergehenden Ansprüche, wobei
die erste Kontaktschicht (2) mindestens einen elektrischen Anschlussbereich (201) aufweist, der zur elektrischen Kontaktierung des Halbleiterkörpers (1) an einer der Strahlungsaustrittsseite (102) zugewandten Seite der aktiven Schicht (101) geeignet ist.

10. Optoelektronische Projektionsvorrichtung nach einem der vorhergehenden Ansprüche, wobei
die erste Kontaktschicht (2) in Form von Strukturen (202) strukturiert ist und eine Mehrzahl von elektrischen Anschlussbereichen (201) aufweist, wobei jeweils eine Struktur (202) mit einem Anschlussbereich (201) elektrisch leitend verbunden ist.

11. Optoelektronische Projektionsvorrichtung nach einem der vorhergehenden Ansprüche, wobei
die zweite Kontaktschicht (3) in Form von Pixeln (301) strukturiert ist und eine Mehrzahl von elektrischen Anschlussflächen (303) aufweist, wobei jeweils ein Pixel (301) mit einer Anschlussfläche (303) elektrisch leitend verbunden ist.

12. Optoelektronische Projektionsvorrichtung nach einem der vorhergehenden Ansprüche, wobei
auf der Strahlungsaustrittsseite (102) bereichsweise Strahlungsauskoppelstrukturen (11) angeordnet sind, wobei die Strahlungsauskoppelstrukturen (11) lediglich auf solchen Bereichen der Strahlungsaustrittsseite (102) des Halbleiterkörpers (1) angeordnet sind, unterhalb derer in vertikaler Richtung jeweils eines der Pixel (301) der zweiten Kontaktschicht (3) angeordnet ist.

13. Optoelektronische Projektionsvorrichtung nach einem der vorhergehenden Ansprüche, wobei
dem Halbleiterkörper (1) auf der Strahlungsaustrittsseite (102) ein optisches Element (5) nachgeordnet ist.

14. Optoelektronische Projektionsvorrichtung nach einem der vorhergehenden Ansprüche, wobei
die erste und/oder die zweite Kontaktschicht (2, 3) einen von der aktiven Schicht (4) in Richtung zu der Rückseite (103) hin emittierten Teil der elektromagnetischen Strahlung in Richtung der Strahlungsaustrittsseite (102) reflektieren.

15. Optoelektronische Projektionsvorrichtung nach einem der vorhergehenden Ansprüche, wobei
die Projektionsvorrichtung Bestandteil eines elektronischen Bauelements (6) ist, insbesondere eines Mobiltelefons, PDAs, Laptops, Computers, Uhr oder Weckers.

## Claims

1. Optoelectronic projection device which generates a predefined image (10) during operation, comprising a semiconductor body (1), which has an active layer (101) suitable for generating electromagnetic radiation and a radiation exit side (102), wherein, for making electrical contact with the semiconductor body (1) a first contact layer (2) and a second contact layer (3) are arranged at a rear side (103) of the semiconductor body (1), said rear side lying opposite the radiation exit side (102), and are electrically insulated from one another by means of a separating layer (4), and wherein a partial region (203) of the first contact layer (2) extends from the rear side (103) through at least one perforation (104) in the active layer (101) in the direction toward the radiation exit side (102), **characterized in that**
the semiconductor body (1) is an imaging element of the projection device and the second contact layer (3) is structured in the form of pixels (301), wherein at least one part of the predefined image (10) arises as a result of the projection of the pixels (301) during the operation of the projection device.

2. Optoelectronic projection device according to Claim 1, wherein
the first contact layer (2) is arranged at that side of the second contact layer (3) which is remote from the semiconductor body (1), the second contact layer (3) and the electrically insulating separating layer (4) per pixel (301) has a plurality of openings (302), and the first contact layer (2) runs through the openings (302) to the semiconductor body (1), and
wherein the radiation exit side (102) of the semiconductor body (1) is free of electrical connection locations.

3. Optoelectronic projection device according to Claim 2, wherein
the pixels (301) are arranged in a two-dimensional segment display.

4. Optoelectronic projection device according to Claim 2, wherein
the pixels (301) are arranged in a two-dimensional regular matrix composed of n rows and m columns.

5. Optoelectronic projection device according to Claim 1, wherein
the second contact layer (3) has at least one structure (301b) in the form of a pictogram, character, letter or lettering.

6. Optoelectronic projection device according to any of the preceding claims, wherein
the active layer (101) is a continuous and connected layer extending over all the pixels (301).

7. Optoelectronic projection device according to any of the preceding claims, wherein
the semiconductor body (1) including active layer (101) is structured to form a pattern, wherein at least one part of the predefined image (10) arises as a result of the projection of the pattern during the operation of the projection device.

8. Optoelectronic projection device according to the preceding claim, wherein
the semiconductor body (1) is completely removed in regions and removed regions (8) thereby result,
wherein the removed regions (8) are filled with a reflective material (81) and the first contact layer (2) is embodied as a planar mirror that extends in a lateral direction over all the pixels (301).

9. Optoelectronic projection device according to any of the preceding claims, wherein
the first contact layer (2) has at least one electrical connection region (201) suitable for making electrical contact with the semiconductor body (1) at a side of the active layer (101) which faces the radiation exit side (102).

10. Optoelectronic projection device according to any of the preceding claims, wherein
the first contact layer (2) is structured in the form of structures (202) and has a plurality of electrical connection regions (201), wherein a structure (202) is in each case electrically conductively connected to a connection region (201).

11. Optoelectronic projection device according to any of the preceding claims, wherein
the second contact layer (3) is structured in the form of pixels (301) and has a plurality of electrical connection pads (303), wherein a pixel (301) is in each case electrically conductively connected to a connection pad (303).

12. Optoelectronic projection device according to any of the preceding claims, wherein
radiation coupling-out structures (11) are arranged in regions on the radiation exit side (102), wherein the radiation coupling-out structures (11) are arranged only on such regions of the radiation exit side (102) of the semiconductor body (1) below which one of the pixels (301) of the second contact layer (3) is in each case arranged in a vertical direction.

13. Optoelectronic projection device according to any of the preceding claims, wherein
an optical element (5) is disposed downstream of the semiconductor body (1) on the radiation exit side (102).

14. Optoelectronic projection device according to any of the preceding claims, wherein
the first and/or the second contact layer (2, 3) reflect(s) part of the electromagnetic radiation, said part being emitted from the active layer (4) in the direction toward the rear side (103), in the direction of the radiation exit side (102).

15. Optoelectronic projection device according to any of the preceding claims, wherein
the projection device is part of an electronic component (6), in particular of a mobile telephone, PDA, laptop, computer, clock or alarm clock.

## Revendications

1. Dispositif de projection opto-électronique, qui génère en fonctionnement une image prescrite (10), comprenant un corps semi-conducteur (1), qui présente une couche active (101) appropriée pour générer un rayonnement électromagnétique et un côté de sortie de rayonnement (102), dans lequel à des fins de contact électrique du corps semi-conducteur (1) une première couche de contact (2) et une deuxième couche de contact (3) sont disposées sur un côté arrière (103) du corps semi-conducteur (1) en vis-à-vis du côté de sortie de rayonnement (102) et sont isolées électriquement l'une de l'autre au moyen d'une couche de séparation (4), et
dans lequel une zone partielle (203) de la première couche de contact (2) s'étend à partir du côté arrière (103) à travers au moins une percée (104) de la couche active (101) dans la direction allant vers le côté de sortie de rayonnement (102),
**caractérisé en ce que**
le corps semi-conducteur (1) est un élément donnant une image du dispositif de projection et la deuxième couche de contact (3) est structurée en forme de pixels (301), dans lequel au moins une partie de l'image prescrite (10) résulte de la projection des pixels (301) pendant le fonctionnement du dispositif de projection.

2. Dispositif de projection opto-électronique selon la revendication 1, dans lequel
la première couche de contact (2) est disposée sur le côté de la deuxième couche de contact (3) qui se détourne du corps semi-conducteur (1), la deuxième couche de contact (3) et la couche de séparation (4) isolante électriquement présentent par pixel (301) une pluralité d'ouvertures (302), et la première couche de contact (2) s'étend à travers les ouvertures (302) vers le corps semi-conducteur (1), et
dans lequel le côté de sortie de rayonnement (102) du corps semi-conducteur (1) est exempt de points de connexion électriques.

3. Dispositif de projection opto-électronique selon la revendication 2, dans lequel
les pixels (301) sont disposés dans un affichage à segment en deux dimensions.

4. Dispositif de projection opto-électronique selon la revendication 2, dans lequel
les pixels (301) sont disposés dans une matrice régulière en deux dimensions composée de n lignes et m colonnes.

5. Dispositif de projection opto-électronique selon la revendication 1, dans lequel
la deuxième couche de contact (3) présente au moins une structure (301b) sous forme d'un pictogramme, un signe, une lettre ou un caractère.

6. Dispositif de projection opto-électronique selon une des revendications précédentes, dans lequel
la couche active (101) est une couche d'un seul tenant et continue, s'étendant sur tous les pixels (301) .

7. Dispositif de projection opto-électronique selon une des revendications précédentes, dans lequel
le corps semi-conducteur (1) y compris la couche active (101) est structuré en un motif, dans lequel au moins une partie de l'image prescrite (10) résulte de la projection du modèle pendant le fonctionnement du dispositif de projection.

8. Dispositif de projection opto-électronique selon la revendication précédente, dans lequel
le corps semi-conducteur (1) est complètement éliminé par endroits et des zones ainsi éliminées (8) en résultent,
dans lequel les zones éliminées (8) sont remplies avec un matériau (81) réfléchissant et la première couche de contact (2) est conçue comme un miroir plat, qui s'étend dans la direction latérale sur tous les pixels (301).

9. Dispositif de projection opto-électronique selon une des revendications précédentes, dans lequel
la première couche de contact (2) présente au moins une zone de connexion électrique (201), qui est appropriée au contact électrique du corps semi-conducteur (1) sur un côté tourné vers le côté de sortie de rayonnement (102) de la couche active (101) .

10. Dispositif de projection opto-électronique selon une des revendications précédentes, dans lequel la première couche de contact (2) est structurée sous forme de structures (202) et présente une pluralité de zones de connexion électriques (201), dans lequel respectivement une structure (202) est reliée de manière électriquement conductrice avec une zone de connexion (201).

11. Dispositif de projection opto-électronique selon une des revendications précédentes, dans lequel
la deuxième couche de contact (3) est structurée sous forme de pixels (301) et présente une pluralité de surfaces de connexion électriques (303), dans lequel respectivement un pixel (301) est relié de manière électriquement conductrice avec une surface de connexion (303).

12. Dispositif de projection opto-électronique selon une des revendications précédentes, dans lequel
sur le côté de sortie de rayonnement (102), des structures de découplage de rayonnement (11) sont disposées par endroits, dans lequel les structures de découplage de rayonnement (11) sont disposées uniquement sur des zones du côté de sortie de rayonnement (102) du corps semi-conducteur (1), au-dessous desquelles dans la direction verticale respectivement un des pixels (301) de la deuxième zone de contact (3) est disposé.

13. Dispositif de projection opto-électronique selon une des revendications précédentes, dans lequel
un élément optique (5) est disposé postérieurement au corps semi-conducteur (1) sur le côté de sortie de rayonnement (102).

14. Dispositif de projection opto-électronique selon une des revendications précédentes, dans lequel
la première et/ou la deuxième couche de contact (2, 3) réfléchissent une partie émise à partir de la couche active (4) dans la direction allant vers le côté arrière (103), du rayonnement électromagnétique dans la direction du côté de sortie de rayonnement (102).

15. Dispositif de projection opto-électronique selon une des revendications précédentes, dans lequel
le dispositif de projection est partie intégrante d'un composant électronique (6), notamment d'un téléphone mobile, assistant numérique personnel, ordinateur portable, ordinateur, montre ou réveil.
